# EUROPÄISCHE PATENTSCHRIFT

(11) **EP 3 526 158 B1**
(45) Veröffentlichungstag und Bekanntmachung des Hinweises auf die Patenterteilung: **14.02.2024**
(21) Anmeldenummer: 17780029.9
(22) Anmeldetag: 18.09.2017
(51) Int. Cl.: B81B 7/00, G01L 19/14, G01L 9/00, G01L 19/00

(54) **VERFAHREN ZUM HERSTELLEN EINES STRESSENTKOPPELTEN MIKROMECHANISCHEN DRUCKSENSORS**
METHOD FOR PRODUCING A STRESS-DECOUPLED MICROMECHANICAL PRESSURE SENSOR
PROCÉDÉ POUR PRODUIRE UN CAPTEUR DE PRESSION MICROMÉCANIQUE DÉCOUPLÉ DE CONTRAINTES

(30) Priorität: 14.10.2016 DE 102016220077
(43) Veröffentlichungstag der Anmeldung: 21.08.2019
(73) Patentinhaber: Robert Bosch GmbH, 70442 Stuttgart (DE)
(72) Erfinder: KRAMER, Torsten, 72827 Wannweil (DE); FRIEDRICH, Thomas, 72116 Moessingen-Oeschingen (DE); DANNENBERG, Arne, 72555 Metzingen (DE); FRITZ, Joachim, 72074 Tuebingen (DE)
(86) Internationale Anmeldenummer: PCT/EP2017/073447
(87) Internationale Veröffentlichungsnummer: WO 2018/068991

(56) Entgegenhaltungen:
- DE-A1-102004 043 356
- DE-A1-102015 116 353

## Beschreibung

Die Erfindung betrifft ein Verfahren zum Herstellen eines mikromechanischen Drucksensors. Die Erfindung betrifft ferner einen mikromechanischen Drucksensor.

### Stand der Technik

Mikromechanische Drucksensoren, bei denen eine Druckdifferenz in Abhängigkeit von einer Verformung einer Sensormembran gemessen wird, sind beispielsweise aus DE 10 2004 006 197 A1 bekannt.

Halbleiterwiderstände, die bei bekannten mikromechanischen Drucksensoren als mechanisch-elektrische Wandler verwendet werden, nehmen nicht nur den mechanischen Stress auf, der sich durch den Druckeinfluss auf die Membran ergibt, sondern auch Stress durch mechanische Störeinflüsse. Die beiden wichtigsten Störeinflüsse sind dabei folgende:
- Eingekoppelter Stress seitens der Aufbau- und Verbindungstechnik (AVT) durch:
   - Verformung der Leiterplatte, auf die der Sensor montiert ist
   - Verformung des Gehäuses über Temperatur, z.B. durch Löten
   - Temperaturverhalten eines verwendeten Klebers
- Intrinsischer Stress aus dem Sensorelement durch Temperaturverhalten von Deckschichten

Teilweise sind die genannten Effekte durch einen geeigneten Abgleich zu beherrschen, zum Beispiel bei den dielektrischen Deckschichten. Der Einfluss der Metallisierung sowie des AVT-seitig eingekoppelten Stresses unterliegt einer erheblichen Abhängigkeit von einer Historie des Bauteils (z.B. aufgrund von Kriechen des Metalls, insbesondere beim/nach dem Löten). Dies kann nicht durch einen Abgleich vor Auslieferung der Bauelemente kompensiert werden.

DE 10 2015 116 353 A1 offenbart einen mikrointegrierten gekapselten MEMS-Sensor mit mechanischer Entkopplung und ein Herstellungsverfahren hierfür. Dabei wird der auf einem SOI-Substrat hergestellte Drucksensor von der Rückseite durch Herausätzen der vergrabenen Oxidschicht, z.B. mittels HF-Gasphasenätzen freigestellt. Die Zuleitung des Ätzgases erfolgt dabei durch zuvor in das Silizium der Waferrückseite getrenchte Zugangslöcher.

Entsprechend offenbart dieses Dokument einen mikromechanischen Drucksensor, aufweisend einen MEMS-Wafer mit einem Siliziumsubstrat und einer darin ausgebildeten ersten Kavität unter einer Sensormembran, wobei die Sensormembran an einer Unterseite des MEMS-Wafers angeordnet ist, einen an der Unterseite des MEMS-Wafers mit einer ersten Seite gebondeten zweiten Wafer, wobei die Unterseite des MEMS-Wafers Metallisierungselemente zum Ausbilden der Bondverbindung aufweist und einen in einem Siliziumsubstrat ausgebildeten Sensorkern mit Bulk-Silizium und der Sensormembran, wobei zwischen der Sensormembran und dem Bulk-Silizium die erste Kavität ausgebildet ist.

Das Herstellungsverfahren umfasst u. a. die Schritte Bereitstellen eines MEMS-Wafers mit einem Siliziumsubstrat und einer darin ausgebildeten ersten Kavität zwischen einer Sensormembran und Bulk-Silizium, Bereitstellen eines zweiten Wafers, Bonden einer Unterseite des MEMS-Wafers aufweisend Metallisierungselemente zum Ausbilden der Bondverbindung mit einer ersten Seite des zweiten Wafers, wobei die Sensormembran auf der Unterseite des MEMS-Wafers angeordnet ist und Freistellen eines Sensorkerns mit Bulk-Silizium, der Sensormembran und der ersten Kavität.

### Offenbarung der Erfindung

Es ist eine Aufgabe der vorliegenden Erfindung, ein alternatives Herstellverfahren für einen mikromechanischen Drucksensor mit verbessertem Betriebsverhalten bereit zu stellen.

Die Aufgabe wird gemäß einem ersten Aspekt gelöst mit einem Verfahren zum Herstellen eines mikromechanischen Drucksensors, aufweisend die Schritte:
- Bereitstellen eines MEMS-Wafers mit einem Siliziumsubstrat und einer darin ausgebildeten ersten Kavität zwischen einer Sensormembran und Bulk-Silizium;
- Bereitstellen eines zweiten Wafers;
- Eutektisches Bonden einer Unterseite des MEMS-Wafers aufweisend Metallisierungselemente zum Ausbilden der eutektischen Bondverbindung mit einer ersten Seite des zweiten Wafers, wobei die Sensormembran auf der Unterseite des MEMS-Wafers angeordnet ist; und
- Freistellen eines Sensorkerns mit Bulk-Silizium, der Sensormembran und der ersten Kavität von der Oberseite des MEMS-Wafers her, wobei eine zweite Kavität im Bulk-Silizium zwischen dem Sensorkern und der Oberfläche des Siliziumsubstrats durch die Zugangsöffnungen auf der Oberseite des ersten Wafers geätzt wird.

Auf diese Weise wird ein mikromechanischer Drucksensor mit einer allseitig freigestellten Drucksensormembran bereitgestellt, wodurch eine effiziente Stressentkopplungsstruktur realisiert ist. Durch eine Änderung eines Ätzregimes ist die Bereitstellung der dazu erforderlichen zweiten Kavität innerhalb des Siliziumsubstrats möglich. Auf diese Weise werden zugleich ein wirksamer

Schutz vor Verschmutzung und ein Medienzugang für den mikromechanischen Drucksensor geschaffen. Fehlsignale des mikromechanischen Drucksensors können auf diese Weise stark reduziert werden, wodurch eine Betriebscharakteristik des Drucksensors verbessert ist. Mittels der Stützwirkung des zweiten Wafers, der mit dem MEMS-Wafer gebondet ist, kann der gesamte Prozess von der Rückseite her auf komfortable Weise durchgeführt werden.

Gemäß einem zweiten Aspekt wird die Aufgabe gelöst mit einem mikromechanischen Drucksensor, aufweisend:
- einen MEMS-Wafer mit einem Siliziumsubstrat und einer darin ausgebildeten ersten Kavität unter einer Sensormembran, wobei die Sensormembran an einer Unterseite des MEMS-Wafers angeordnet ist;
- einen an der Unterseite des MEMS-Wafers mit einer ersten Seite eutektisch gebondeten zweiten Wafer, wobei die Unterseite des MEMS-Wafers Metallisierungselemente zum Ausbilden der eutektischen Bondverbindung aufweist;
- einen in einem Siliziumsubstrat ausgebildeten Sensorkern mit Bulk-Silizium und der Sensormembran, wobei zwischen der Sensormembran und dem Bulk-Silizium die erste Kavität ausgebildet ist; und
- eine im Bulk-Silizium zwischen dem Sensorkern und der Oberseite des ersten Wafers ausgebildete zweite Kavität mit Zugangsöffnungen auf der Oberseite des ersten Wafers.

Bevorzugte Ausführungsformen des Verfahrens zum Herstellen eines mikromechanischen Drucksensors sind Gegenstand von abhängigen Ansprüchen.

Eine vorteilhafte Weiterbildung des Verfahrens sieht vor, dass zum Ausbilden der zweiten Kavität der Ätzprozess ein reaktiver lonen-Tiefätzprozess mit anisotropem Beginn und definiert isotroper Fortsetzung ist. Auf diese Weise werden an sich bekannte Ätzprozesse in vorteilhafter Weise zur Ausbildung der zweiten Kavität verwendet.

Eine weitere vorteilhafte Weiterbildung des Verfahrens sieht vor, dass zum Ausbilden der zweiten Kavität mittels eines senkrechten Ätzprozesses Zugangsöffnungen im Siliziumsubstrat erzeugt werden, wobei der senkrechte Ätzprozess in einen seitlichen Ätzprozess geändert wird, wobei aus dem seitlichen Ätzprozess resultierende kugelförmige Ätzfronten zusammenwachsen. Dadurch werden auf vorteilhafte Weise spezifische Eigenschaften von an sich bekannten Ätzprozessen zur Bereitstellung der zweiten Kavität ausgenutzt. Eine weitere vorteilhafte Weiterbildung des Verfahrens zeichnet sich dadurch aus, dass nach dem reaktiven lonen-Tiefätzprozesses ein Passivier- und SputterAnteil des Ätzprozesses abgeschaltet wird. Dadurch werden auf wirkungsvolle Weise Maßnahmen zur Anpassung von an sich bekannten Ätzprozessen zur Schaffung der zweiten Kavität getroffen.

Eine weitere vorteilhafte Weiterbildung des Verfahrens sieht vor, dass der gesamte Ätzprozess von Beginn an definiert isotrop ausgebildet ist. Auf diese Weise wird vorteilhaft eine alternative Herstellungsmethode bereitgestellt.

Eine weitere vorteilhafte Weiterbildung des Verfahrens sieht vor, dass mittels des Ätzprozesses von Beginn an nach unten aufweitende, trapezartige Ätzfronten ausgebildet werden. Auf diese Weise wird vorteilhaft ein nach unten ausgebildetes trapezförmig aufweitendes Ätzregime bereitgestellt, wodurch vorteilhaft ein Einführen von Ätzgas erleichtert ist. Zudem können dadurch Ätzzeiten reduziert und der gesamte Prozess besser kontrolliert werden.

Eine weitere vorteilhafte Weiterbildung des Verfahrens sieht vor, dass der zweite Wafer ein passiver Substratwafer oder ein ASIC-Wafer ist. Dadurch werden vorteilhaft unterschiedliche Möglichkeiten für die Ausbildung des zweiten Wafers realisiert.

Eine weitere vorteilhafte Weiterbildung des Verfahrens sieht vor, dass der mikromechanische Drucksensor als ein piezoresistiver Drucksensor oder als ein kapazitiver Drucksensor ausgebildet wird. Auf diese Weise können unterschiedliche technologische Typen von mikromechanischen Drucksensoren realisiert werden.

Die Erfindung wird im Folgenden mit weiteren Merkmalen und Vorteilen anhand von mehreren Figuren im Detail beschrieben. Gleiche oder funktionsgleiche Elemente haben gleiche Bezugszeichen. Die Figuren sind insbesondere dazu gedacht, die erfindungswesentlichen Prinzipien zu verdeutlichen und sind nicht unbedingt maßstabsgetreu ausgeführt. Der besseren Übersichtlichkeit halber kann vorgesehen sein, dass nicht in sämtlichen Figuren sämtliche Bezugszeichen eingezeichnet sind.

Offenbarte Verfahrensmerkmale ergeben sich analog aus entsprechenden offenbarten Vorrichtungsmerkmalen und umgekehrt. Dies bedeutet insbesondere, dass sich Merkmale, technische Vorteile und Ausführungen betreffend das Verfahren zum Herstellen eines mikromechanischen Drucksensors in analoger Weise aus entsprechenden Ausführungen, Merkmalen und technischen Vorteilen des mikromechanischen Drucksensors ergeben und umgekehrt.

In den Figuren zeigt:
- Fig. 1...4: Querschnittsansichten zur Erläuterung des vorgeschlagenen Verfahrens zum Herstellen eines mikromechanischen Drucksensors;
- Fig. 5 und 6: Querschnittsansichten zur Erläuterung eines alternativen Verfahrens zum Herstellen eines mikromechanischen Drucksensors;
- Fig. 7 und 8: mögliche Endbearbeitungen des vorgeschlagenen mikromechanischen Drucksensors; und
- Fig. 9: einen prinzipiellen Ablauf einer Ausführungsform eines Verfahrens zum Herstellen eines mikromechanischen Drucksensors.

### Beschreibung von Ausführungsformen

Ein Kerngedanke der vorliegenden Erfindung ist die Bereitstellung eines verbesserten Herstellungsverfahrens für einen mikromechanischen Drucksensor. Dazu wird ein spezifisch ausgebildetes Ätzverfahren vorgeschlagen, welches mit einem einfachen, kostengünstigen Si-Substrat durchgeführt werden kann. Erreicht wird auf diese Weise eine effiziente Stressentkopplungsstruktur, die für den mikromechanischen Drucksensor auch eine Schutzeinrichtung für externe Partikel bzw. externe Feuchte realisiert.

Der besseren Übersichtlichkeit halber sind nachfolgend für die Erfindung unwesentliche Strukturen bzw. Elemente nicht näher erläutert.

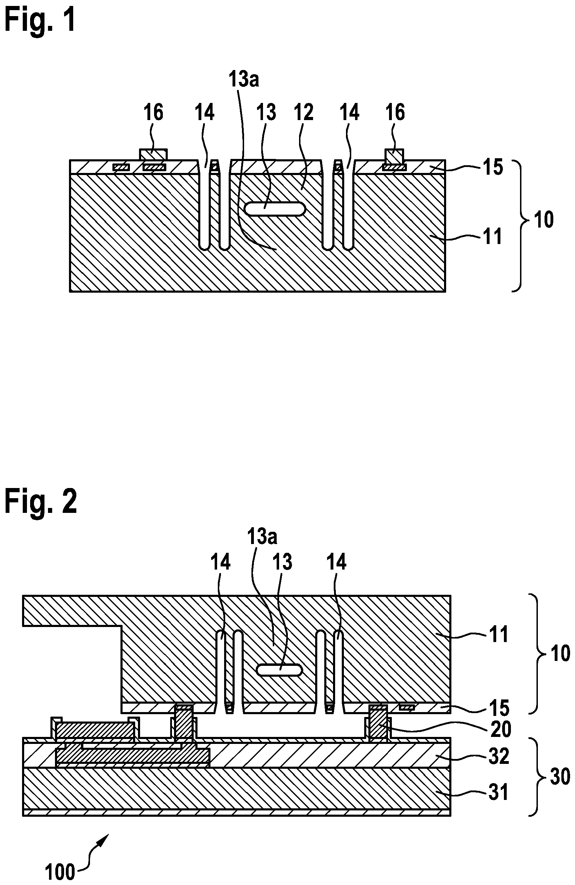

Fig. 1 zeigt eine Querschnittsansicht eines ersten Wafers 10 mit einem Siliziumsubstrat 11, auf dem eine dielektrische Deckschicht 15 angeordnet ist. Innerhalb des Siliziumsubstrats 11 sind erste Zugangsöffnungen 14 und ferner eine erste Kavität 13 ausgebildet. Unterhalb der ersten Kavität 13 ist Bulk-Silizium 13a erkennbar. Ein Metallisierungselement 16 dient zur nachfolgenden Ausbildung einer eutektischen Bondverbindung 20 mit einem zweiten Wafer 30.

Fig. 2 zeigt die Anordnung von Fig. 1 um 180 Grad verdreht, wobei der erste Wafer 10 nunmehr mit einem zweiten Wafer 30 vorzugsweise eutektisch gebondet ist, wodurch eine Bondverbindung 20 geschaffen wurde. Der zweite Wafer 30 kann als ein ASIC-Wafer oder alternativ als ein passiver Substratwafer (nicht dargestellt) ausgebildet sein. Im Falle eines ASIC-Wafers umfasst der zweite Wafer 30 ein ASIC-Substrat 31 und eine darauf angeordnete Funktionsschicht 32. Der derart gebildete Stapel kann rückgedünnt werden (z. B. durch Schleifen), um die Bearbeitungszeit im darauffolgenden Strukturierungsschritt zu verkürzen und um die Bauteilhöhe zu reduzieren.

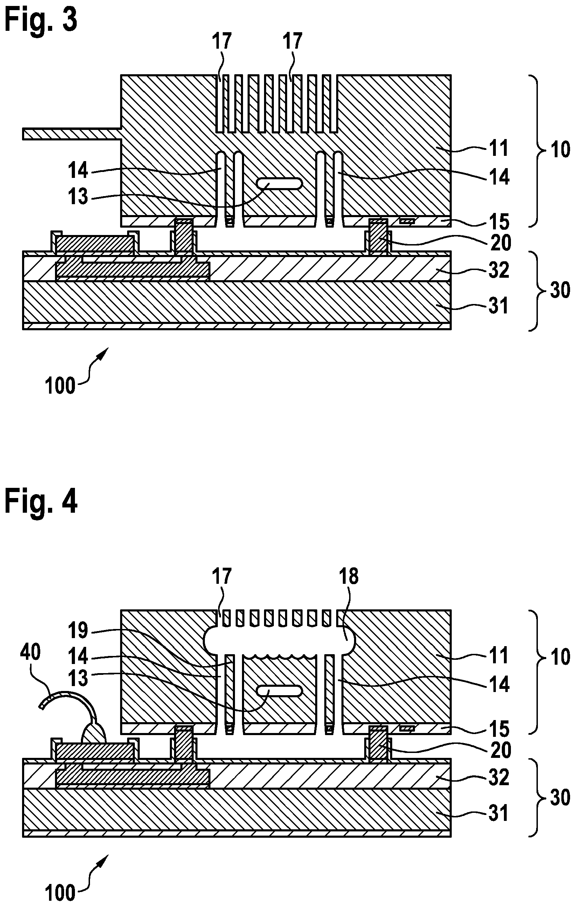

Fig. 3 zeigt eine Querschnittsansicht durch die beiden gebondeten Wafer 10, 30. In einem nächsten Schritt wird mittels Fotolithographie ein Lochmuster im Siliziumsubstrat 11 erzeugt. Das genannte Lochmuster wird anschließend geätzt, vorzugweise mittels eines senkrechten bzw. anisotropen Ätzprozesses, vorzugsweise in Form eines reaktiven lonentiefätzens (engl. deep reactive ion etching, DRIE). Dadurch werden zweite Zugangsöffnungen 17 im Siliziumsubstrat 11 ausgebildet. Die Ätzung der der zweiten Zugangsöffnungen 17 stoppt im Bulk-Silizium des Siliziumsubstrats 11. Dieser Strukturierungsschritt kann auch verwendet werden, um in anderen Bereichen großflächige Ätzlöcher zu erzeugen, die zum Beispiel einen Zugang zu Bondbereichen (engl. bondlands) oder Sägegräben schaffen.

Im weiteren Ablauf wird durch ein Ausschalten des Passivier- und Sputteranteils im genannten DRIE-Ätzprozess mit einer ungerichteten bzw. isotropen Weiterätzung am Grund der zweiten Zugangsöffnungen 17 eine Unterätzung erreicht. Aus einem Bereich mit Sacklöchern wird auf diese Weise ein freistehendes Gitter ohne mechanischen Kontakt zum Sensorkern. Ein Drahtbond- bzw. Sägegrabenbereich kann in diesem Schritt freigeätzt werden.

Fig. 4 zeigt eine Konsequenz des genannten, geänderten Ätzregimes während der Ausbildung der zweiten Zugangsöffnungen 17. Man erkennt, dass aufgrund der geänderten Ätzparameter im Siliziumsubstrat 11 nunmehr kugelförmige Ätzfronten zusammengewachsen sind und auf diese Weise eine zweite Kavität 18 bilden. Die zweite Kavität 18 wird durch ein Gitter, das im Siliziumsubstrat 11 durch die ersten Zugangsöffnungen 17 gebildet wurde, vom restlichen Substrat getrennt. Der Drucksensorkern ist mittels Federn 19, die elektrische Zuleitungen (nicht dargestellt) aufweisen, an das restliche Substrat angebunden.

Im Ergebnis ist damit durch die nunmehr durchgängigen ersten Zugangsöffnungen 14, die zweite Kavität 18 und die durchgängigen zweiten Zugangsöffnungen 17 für die Sensormembran 12 eine allseitige Freistellung und damit eine mechanische Entkopplungsstruktur gegen extern einwirkenden mechanischen Stress geschaffen. Dadurch wird, abgesehen von elektrischen Zugängen und einer mechanischen Fixierung des Drucksensorkerns, eine allseitige mechanische Entkopplung des Drucksensorkerns geschaffen, um auf vorteilhafte Weise mechanische Einflüsse vom Chiprand auf den Drucksensorkern zu minimieren.

Durchmesser der zweiten Zugangsöffnungen 17 werden dabei vorzugsweise derart dimensioniert, dass für Medienzugänge des Drucksensors geeignete Zugangskanäle geschaffen werden. Die zweiten Zugangsöffnungen 17 realisieren auf diese Weise auch einen wirkungsvollen Schutz des Drucksensorkerns vor Partikel und/oder Feuchte (z.B. aufgrund von Spritzwasser).

Auf einfache Weise wurde damit der für die genannte Struktur erforderliche Hohlraum in Form der zweiten Kavität 18 mittels eines Ätzprozesses mit während der Durchführung geänderten Ätzparametern bereitgestellt. Erkennbar ist, dass innerhalb der zweiten Kavität 18 als Folge der isotropen Ätzphase teilsphärische Flächen ausgebildet sind.

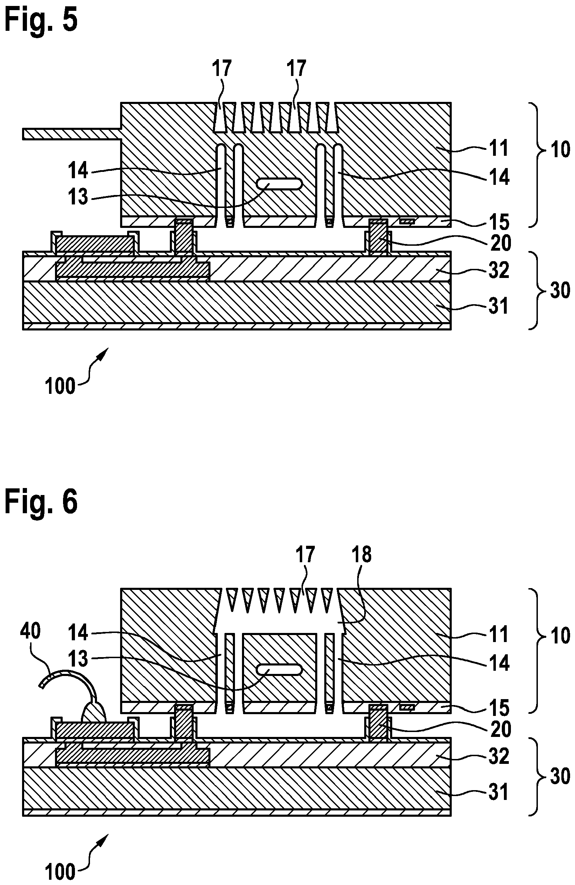

Fig. 5 zeigt eine Querschnittansicht durch einen mikromechanischen Drucksensor 100, der nach einem alternativen Verfahren hergestellt wurde. Man erkennt, dass in diesem Fall die zweiten Zugangsöffnungen 17 mit gleichmäßig aufweitenden Ätzfronten ausgebildet werden, die sich trapezartig von der Oberfläche des Siliziumsubstrats 11 nach unten aufweiten. Dies kann dadurch erreicht werden, dass der oben genannte DRIE-Prozess derart gesteuert wird, dass einzelne Ätzfronten, die durch die zweiten Zugangsöffnungen 17 auf der Substratrückseite definiert sind, im Verlaufe des Prozesses zusammenlaufen und als eine einheitliche Ätzfront den Drucksensorkern von der Rück- bzw. Oberseite des Siliziumsubstrats 11 trennen.

Im Ergebnis ist somit, wie in Fig. 6 erkennbar, die zweite Kavität 18 gegen die Oberfläche des Siliziumsubstrats 11 und seitlich hin aus den trapezförmigen Ätzfronten gebildet. Im Ergebnis können auf diese Weise Ätzgase leichter eingeführt werden und der gesamte Ätzprozess ist vorteilhaft gut steuerbar.

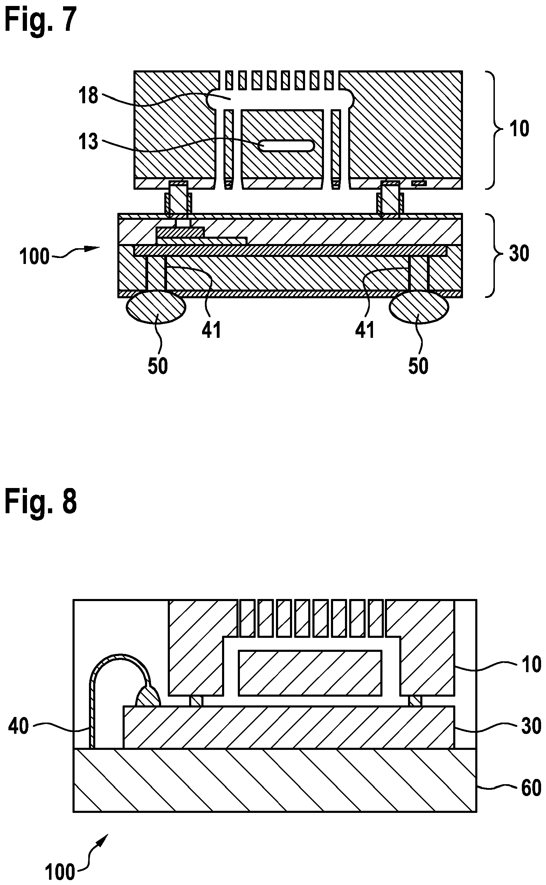

Die Figuren 7 und 8 zeigen Ergebnisse von anschließenden finalen Bearbeitungsschritten für den mikromechanischen Drucksensor 100. In Fig. 7 ist ein elektrisches Anschließen des mikromechanischen Drucksensors 100 mittels einer elektrischen Durchkontaktierung 41 und Lötbällen 50 angedeutet.

Fig. 8 zeigt einen mikromechanischen Drucksensor 100, der mit Moldmasse umspritzt ist, wodurch für den mikromechanischen Drucksensor 100 ein stabiles und widerstandsfähiges Gehäuse bereitgestellt wird. Vorteilhaft ist auf diese Weise ein stressentkoppelter Drucksensor mit einem kostengünstigen ersten Wafer 10 mit einem Siliziumsubstrat 11 bereitgestellt. Eine Verwendung von kostenintensiven Substraten, z.B. in Form eines SOI-Substrats für den ersten MEMS-Wafer 10, ist auf diese Weise nicht erforderlich. Dadurch können beim Herstellen eines stressentkoppelten, mikromechanischen Drucksensors vorteilhaft Kostenvorteile erreicht werden.

Vorzugweise wird der mikromechanische Drucksensor 100 als ein piezoresistiver Drucksensor ausgebildet, denkbar ist aber auch eine Realisierung als kapazitiver mikromechanischer Drucksensor.

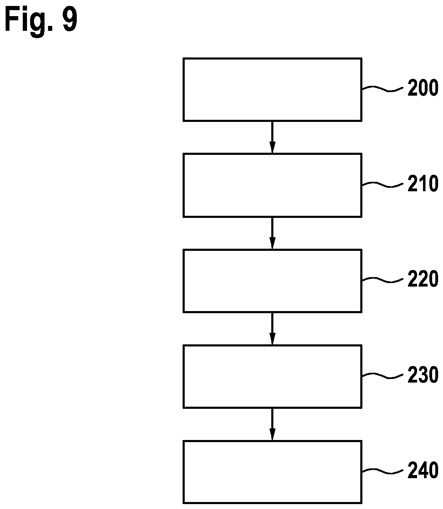

Fig. 9 zeigt einen prinzipiellen Ablauf eines Verfahrens zum Herstellen eines mikromechanischen Drucksensors 100.

In einem Schritt 200 wird ein MEMS-Wafer 10 mit einem Siliziumsubstrat 11 und einer darin ausgebildeten ersten Kavität 13 unter einer Sensor-Siliziummembran 12 bereitgestellt.

In einem Schritt 210 wird ein zweiter Wafer 30 bereitgestellt.

In einem Schritt 220 wird ein Bonden des MEMS-Wafers 10 mit dem zweiten Wafer 30 durchgeführt.

Schließlich wird in einem Schritt 240 ein Freistellen eines Sensorkerns 12, 13, 13a von der Rückseite her durchgeführt, wobei eine zweite Kavität 18 zwischen dem Sensorkern 12, 13, 13a und der Oberfläche des Siliziumsubstrats 11 ausgebildet wird, wobei die zweite Kavität 18 mittels eines Ätzprozesses, der mit definiert geänderten Ätzparametern durchgeführt wird, ausgebildet wird.

Zusammenfassend wird mit der vorliegenden Erfindung ein Verfahren zum Herstellen eines mikromechanischen Drucksensors vorgeschlagen, mit dem auf kostengünstige Weise eine Stressentkopplungsstruktur bereitstellbar ist. Erreicht wird dies durch eine Änderung eines Ätzregimes bei einer Ausbildung einer zweiten Kavität innerhalb des ersten Wafers oberhalb der Drucksensormembran.

Obwohl die Erfindung vorgehend anhand von konkreten Anwendungsbeispielen beschrieben worden ist, kann der Fachmann vorgehend auch nicht oder nur teilweise offenbarte Ausführungsformen der Erfindung realisieren, ohne vom Kern der Erfindung abzuweichen.

## Patentansprüche

1. Verfahren zum Herstellen eines mikromechanischen Drucksensors (100), aufweisend die Schritte:
- Bereitstellen eines MEMS-Wafers (10) mit einem Siliziumsubstrat (11) und einer darin ausgebildeten ersten Kavität (13) zwischen einer Sensormembran (12) und Bulk-Silizium (13a);
- Bereitstellen eines zweiten Wafers (30);
- Eutektisches Bonden einer Unterseite des MEMS-Wafers (10) aufweisend Metallisierungselemente (16) zum Ausbilden der eutektischen Bondverbindung (20) mit einer ersten Seite des zweiten Wafers (30), wobei die Sensormembran (12) auf der Unterseite des MEMS-Wafers (10) angeordnet ist; und
- Freistellen eines Sensorkerns (12, 13, 13a) mit Bulk-Silizium (13a), der Sensormembran (12) und der ersten Kavität (13) von der Oberseite des MEMS-Wafers (10) her, wobei eine zweite Kavität (18) im Bulk-Silizium zwischen dem Sensorkern (12, 13, 13a) und der Oberfläche des Siliziumsubstrats (11) durch die Zugangsöffnungen (17) auf der Oberseite des ersten Wafers (10) geätzt wird.

2. Verfahren nach Anspruch 1, wobei zum Ausbilden der zweiten Kavität (18) der Ätzprozess ein reaktiver lonen-Tiefätzprozess mit anisotropem Beginn und definiert isotroper Fortsetzung ist.

3. Verfahren nach Anspruch 1 oder 2, wobei zum Ausbilden der zweiten Kavität (18) mittels eines senkrechten Ätzprozesses Zugangsöffnungen (17) im Siliziumsubstrat (11) erzeugt werden, wobei der senkrechte Ätzprozess in einen seitlichen Ätzprozess geändert wird, wobei aus dem seitlichen Ätzprozess resultierende kugelförmige Ätzfronten zusammenwachsen.

4. Verfahren nach Anspruch 2 oder 3, wobei nach dem reaktiven lonen-Tiefätzprozesses ein Passivier- und Sputteranteil des Ätzprozesses abgeschaltet wird.

5. Verfahren nach Anspruch 1, wobei der gesamte Ätzprozess von Beginn an definiert isotrop ausgebildet ist.

6. Verfahren nach Anspruch 5, wobei mittels des Ätzprozesses nach unten aufweitende, trapezartige Ätzfronten ausgebildet werden.

7. Verfahren nach einem der vorhergehenden Ansprüche, wobei der zweite Wafer (30) ein passiver Substratwafer oder ein ASIC-Wafer ist.

8. Verfahren nach einem der vorhergehenden Ansprüche, wobei der mikromechanische Drucksensor (100) als ein piezoresistiver Drucksensor oder als ein kapazitiver Drucksensor ausgebildet wird.

9. Mikromechanischer Drucksensor (100), aufweisend:
- einen MEMS-Wafer (10) mit einem Siliziumsubstrat (11) und einer darin ausgebildeten ersten Kavität (13) unter einer Sensormembran (12), wobei die Sensormembran (12) an einer Unterseite des MEMS-Wafers (10) angeordnet ist;
- einen an der Unterseite des MEMS-Wafers (10) mit einer ersten Seite eutektisch gebondeten zweiten Wafer, wobei die Unterseite des MEMS-Wafers (10) Metallisierungselemente (16) zum Ausbilden der eutektischen Bondverbindung (20) aufweist;
- einen in einem Siliziumsubstrat (11) ausgebildeten Sensorkern (12, 13, 13a) mit Bulk-Silizium (13a) und der Sensormembran (12), wobei zwischen der Sensormembran (12) und dem Bulk-Silizium (13a) die erste Kavität (13) ausgebildet ist;
- eine im Bulk-Silizium (13a) zwischen dem Sensorkern (12, 13, 13a) und der Oberseite des ersten Wafers (10) ausgebildete zweite Kavität (18) mit Zugangsöffnungen (17) auf der Oberseite des ersten Wafers (10).

10. Mikromechanischer Drucksensor (100) nach Anspruch 9, **dadurch gekennzeichnet, dass** zum Ausbilden der zweiten Kavität (18) der mikromechanische Drucksensor (100) mittels eines reaktiven lonen-Tiefätzprozesses mit isotropem Beginn und definiert isotroper Fortsetzung ausgebildet wurde.

11. Mikromechanischer Drucksensor (100) nach Anspruch 10, **dadurch gekennzeichnet, dass** der mikromechanische Drucksensor (100) ein piezoresistiver oder ein kapazitiver Drucksensor ist.

## Claims

1. Method for producing a micromechanical pressure sensor (100), comprising the following steps:
- providing a MEMS wafer (10) comprising a silicon substrate (11) and a first cavity (13) formed therein between a sensor membrane (12) and bulk silicon (13a);
- providing a second wafer (30);
- eutectic bonding of an underside of the MEMS wafer (10) having metallization elements (16) for forming the eutectic bond connection (20) to a first side of the second wafer (30), wherein the sensor membrane (12) is arranged on the underside of the MEMS wafer (10); and
- freeing a sensor core (12, 13, 13a) comprising bulk silicon (13a), the sensor membrane (12) and the first cavity (13) from the top side of the MEMS wafer (10), wherein a second cavity (18) is etched in the bulk silicon between the sensor core (12, 13, 13a) and the surface of the silicon substrate (11) through the access openings (17) on the top side of the first wafer (10).

2. Method according to Claim 1, wherein for forming the second cavity (18) the etching process is a deep reactive ion etching process with an anisotropic beginning and defined isotropic continuation.

3. Method according to Claim 1 or 2, wherein for forming the second cavity (18) by means of a perpendicular etching process access openings (17) are produced in the silicon substrate (11), wherein the perpendicular etching process is changed into a lateral etching process, wherein spherical etching fronts resulting from the lateral etching process coalesce.

4. Method according to Claim 2 or 3, wherein a passivating and sputtering portion of the etching process is switched off after the deep reactive ion etching process.

5. Method according to Claim 1, wherein the entire etching process is embodied in a defined isotropic manner from the beginning.

6. Method according to Claim 5, wherein trapezium-like etching fronts widening downwards are formed by means of the etching process.

7. Method according to any of the preceding claims, wherein the second wafer (30) is a passive substrate wafer or an ASIC wafer.

8. Method according to any of the preceding claims, wherein the micromechanical pressure sensor (100) is formed as a piezoresistive pressure sensor or as a capacitive pressure sensor.

9. Micromechanical pressure sensor (100), comprising:
- a MEMS wafer (10) comprising a silicon substrate (11) and a first cavity (13) formed therein below a sensor membrane (12), wherein the sensor membrane (12) is arranged on an underside of the MEMS wafer (10);
- a second wafer eutectically bonded by a first side to the underside of the MEMS wafer (10), wherein the underside of the MEMS wafer (10) has metallization elements (16) for forming the eutectic bond connection (20) ;
- a sensor core (12, 13, 13a) comprising bulk silicon (13a) and the sensor membrane (12), said sensor core being formed in a silicon substrate (11), wherein the first cavity (13) is formed between the sensor membrane (12) and the bulk silicon (13a);
- a second cavity (18) formed in the bulk silicon (13a) between the sensor core (12, 13, 13a) and the top side of the first wafer (10) with access openings (17) on the top side of the first wafer (10).

10. Micromechanical pressure sensor (100) according to Claim 9, **characterized in that** for forming the second cavity (18) the micromechanical pressure sensor (100) was formed by means of a deep reactive ion etching process having an isotropic beginning and defined isotropic continuation.

11. Micromechanical pressure sensor (100) according to Claim 10, **characterized in that** the micromechanical pressure sensor (100) is a piezoresistive or a capacitive pressure sensor.

## Revendications

1. Procédé de fabrication d'un capteur de pression micromécanique (100), comprenant les étapes suivantes :
- fourniture d'une plaquette MEMS (10) comportant un substrat de silicium (11) et une première cavité (13) formée dans celui-ci entre une membrane de capteur (12) et du silicium massif (13a) ;
- fourniture d'une deuxième plaquette (30) ;
- soudage eutectique d'une face inférieure de la plaquette MEMS (10) présentant des éléments de métallisation (16) pour former la connexion par soudage eutectique (20) avec une première face de la deuxième plaquette (30), la membrane de capteur (12) étant agencée sur la face inférieure de la plaquette MEMS (10) ; et
- libération d'un coeur de capteur (12, 13, 13a) comportant du silicium massif (13a), la membrane de capteur (12) et la première cavité (13) à partir de la face supérieure de la plaquette MEMS (10), une deuxième cavité (18) étant formée par attaque dans le silicium massif entre le coeur de capteur (12, 13, 13a) et la surface du substrat de silicium (11) à travers les ouvertures d'accès (17) sur la face supérieure de la première plaquette (10).

2. Procédé selon la revendication 1, dans lequel, pour former la deuxième cavité (18), le processus d'attaque est un processus d'attaque ionique réactif en profondeur avec un début anisotrope et une continuation isotrope définie.

3. Procédé selon la revendication 1 ou 2, dans lequel, pour former la deuxième cavité (18), des ouvertures d'accès (17) sont ménagées dans le substrat de silicium (11) au moyen d'un processus d'attaque vertical, le processus d'attaque vertical étant transformé en un processus d'attaque latéral, des fronts d'attaque sphériques résultant du processus d'attaque latéral.

4. Procédé selon la revendication 2 ou 3, dans lequel une partie de passivation et de pulvérisation du processus d'attaque est désactivée après le processus d'attaque ionique réactif en profondeur.

5. Procédé selon la revendication 1, dans lequel l'ensemble du processus d'attaque est conçu de manière isotrope définie au début.

6. Procédé selon la revendication 5, dans lequel des fronts d'attaque trapézoïdaux s'élargissant vers le bas sont formés au moyen du processus d'attaque.

7. Procédé selon l'une quelconque des revendications précédentes, dans lequel la deuxième plaquette (30) est une plaquette de substrat passive ou une plaquette ASIC.

8. Procédé selon l'une quelconque des revendications précédentes, dans lequel le capteur de pression micromécanique (100) est conçu sous la forme d'un capteur de pression piézorésistif ou d'un capteur de pression capacitif.

9. Capteur de pression micromécanique (100), comportant :
- une plaquette MEMS (10) comprenant un substrat de silicium (11) et une première cavité (13) formée dans celui-ci sous une membrane de capteur (12), la membrane de capteur (12) étant agencée sur une face inférieure de la plaquette MEMS (10) ;
- une deuxième plaquette connectée par une première face par soudage eutectique sur la face inférieure de la plaquette MEMS (10), la face inférieure de la plaquette MEMS (10) comportant des éléments de métallisation (16) destinés à former la connexion par soudage eutectique (20) ;
- un noyau de capteur (12, 13, 13a) formé dans un substrat de silicium (11) comprenant du silicium massif (13a) et la membrane de capteur (12), la première cavité (13) étant formée entre la membrane de capteur (12) et le silicium massif (13a) ;
- une deuxième cavité (18) formée dans le silicium massif (13a) entre le noyau de capteur (12, 13, 13a) et la face supérieure de la première plaquette (10), comportant des ouvertures d'accès (17) sur la face supérieure de la première plaquette (10).

10. Capteur de pression micromécanique (100) selon la revendication 9, **caractérisé en ce que**, pour former la deuxième cavité (18), le capteur de pression micromécanique (100) a été formé au moyen d'un processus d'attaque ionique réactif en profondeur avec un début isotrope et une continuation isotrope définie.

11. Capteur de pression micromécanique (100) selon la revendication 10, **caractérisé en ce que** le capteur de pression micromécanique (100) est un capteur de pression piézorésistif ou capacitif.
